# EUROPEAN PATENT APPLICATION

(11) **EP 0 737 902 A2**
(43) Date of publication of application: **16.10.1996**
(21) Application number: 96600004.4
(22) Date of filing: 11.03.1996
(51) Int. Cl.: G03H 1/02, B23K 26/00, G03F 7/00

(54) **Etching of optical microstructures and uses**

(30) Priority: 09.03.1995 GR 95010097
(71) Applicant: Foundation for Research and Technology-Hellas (FO.R.T.H.), Institute of Electronic Structure and Laser, 711 10 Heraklion (Crete) (GR)
(72) Inventor: Vainos,Nikolaos A., 33100 Amfissa (GR); Boutsikaris,Leonidas S., Pefki,Athens (GR); Mailis,Sakellaris N., Kallithea,Athens (GR); Pissadakis,Stavros I., Chania,Crete (GR); Fotakis,Konstantinos E., Heraklion,Crete (GR)

(57) **Abstract**

The invention refers to a method and a system for the fabrication of surface relief optical microstructures of very small characteristic dimensions suitable for yielding diffraction according to hologram design requirements based on the direct selective solid materials microetching, by using short wavelength, for example ultraviolet laser light, on the surfaces of solid materials with a main aim the recording of optical information. The method is characterized by the application of strong demagnification and simultaneously high-resolution optical imaging such as to achieve high energy density of radiation, targeting to the selective photodissociation and not to thermal evaporation of materials which may have a generic physical nature and geometrical shape. The invention is applied for the production of holograms, the pattern of which has been designed in a computer, specific optical diffraction elements and generally digitized optical microstructures. The invention includes embodiments in sectors of high interest in which conventional lithographic techniques fail and specifically to mass industrial production sectors in photonic and information technology, security encoding and authenticity verification, building illumination and solar energy collection.

## Description

The invention relates to the fabrication of optical diffractive structures and in particular to surface-relief computer-generated holographic (CGH) microstructures as well as to their various relevant wide range applications as they are described in what follows. The nature of these applications prohibits the use of conventional microetching methods. The range of applications extends from information storage and processing, to security coding and authentication, to solar energy collection, to building illumination and decoration.

Diffractive optical elements (DOE), in the form of surface relief microstructures on host solid substrate materials, are components that make full use of the wave nature of light. In contrast to traditional refractive and reflective optics such as lenses, prisms, and mirrors, whose operation is based on the principles of refraction and reflection, DOE's base their operation on light diffraction and interference effects. Therefore, not only may they possess unique and novel properties, but they can perform multiple functions as well. A wide range of applications has been proposed for the smaller and lighter surface relief DOE's, such as laser-beam shaping, compact optical disk heads, laser scanners, optical spectroscopy, micro-optics, fan-out elements and interconnects for parallel optical processing and telecommunications.

Surface relief diffraction structures can be fabricated by conventional photolithography methods. First, the master hologram pattern is designed and recorded on a suitable photoresist coated substrate by using photographic, or electron beam writing, or laser beam writing techniques. Following the chemical processing of the photoresist, the pattern is transferred on to the host substrate by applying various etching methods such as chemical or dry reactive ion etching, possibly followed by additional material deposition. Optical diffractive elements can also be fabricated by using holographic (interferometric) optical recording methods. Interferometric methods offer high recording resolution, and are used for fabricating holographic optical elements and also special elements as for example distributed feedback systems. The small flexibility and the difficulties in the control and reproducibility of the recording process limits the wide application of this scheme.

Computer generated holograms (CGH), and binary phase (Dammann) gratings which are of particular interest to the present invention have been fabricated so far by applying the standard lithographic methods outlined above. Although these microfabrication methods are now well established they suffer with respect to generality of application, simplicity, cost and flexibility. The need of wet and/or dry materials processing, the necessity for suitable substrate materials, the planar substrate geometry requirements, as well as the long processing time and high production cost involved, represent serious disadvantages and the main impediments to the growth of generic holographic systems and their subsequent wide application.

According to the present invention there is provided a method for the direct (one-step) fabrication of diffractive optical surface relief microstructures of arbitrary topography on a large variety of solid materials, utilizing the photodissociative effects (photoablation) of high-intensity short-wavelength laser radiation in combination with high-resolution imaging optical systems for spatially modulating the laser beam and selectively microetch the surfaces of the substrate material. The combination of high resolution with high energy density on the target is accomplished through a strong demagnification optical imaging system (for example x25). Furthermore the invention includes methods for using these optical microstructures in various industrial sectors where the application of conventional techniques is not feasible.

Pulsed excimer lasers for example, emitting in the ultraviolet (UV) region of the electromagnetic spectrum, are suitable for this application. An optical system transforms and directs the excimer laser beam to perform imaging of a predetermined master-pattern mask with strong demagnification onto the substrate. The selective etching of the substrate is achieved via (explosive) photoablation of the material. This master pattern, which may represent a picture element or the fundamental period of a periodic CGH and the like, may be replicated onto the substrate in a step-and-repeat fashion. Reflection and transmission holograms can be fabricated. Suitable illumination of the surface relief hologram reproduces the image of the design object of the CGH.

UV radiation and particularly excimer laser radiation has been used in deep UV lithography and also in bulk materials micromachining, such as principally cutting, drilling and surface processing. In the first case (lithography) high imaging resolution at relatively low intensities is required, for exposing the photoresist. This method falls in the case of conventional lithography. In the second case high irradiation intensities, lower resolution and large depth-of-focus are necessary to achieve a deep clear cut in the material. The adverse dependence of depth-of-focus and resolution in this case does not permit the high-resolution recording of optical information.

The candidate method has been developed to overcome disadvantages of the above techniques and achieve recording of optical holographic information of extremely high resolution (for example of the order of 1000 lines/mm) in a large variety of solid materials in a direct way, without the need for pre- or post-processing of the recording substrate. In addition, the method has the potential for a wide range of applications in sectors in which conventional lithographic schemes either fail or are considered not cost effective. Materials etching at UV laser wavelengths for depths smaller than 0.5µm is mainly due to photodissociative material ablation processes rather than explosive thermal evaporation of the material, the latter being met by the use of visible or infrared radiation. This inherently non-thermal process, usually achieved by the use of a single laser pulse, results in high etching quality, and minimal thermal damage of the irradiated substrate. However, depending on the nature of the radiation and the target, thermal effects which affect processing quality may still be present. The shorter wavelength of operation allows for a higher imaging resolution and prohibits thermal damage, thus enabling etching of micron-size, and even submicron-size features, limited by diffraction. In addition, the method offers simplicity, high production speed and cost effectiveness, since it is a one-step process requiring no pre- or post-processing of the substrate, in contrast to various wet or dry etching methods used in conventional microfabrication technology. The procedure is not material specific, and it can also be applied to highly durable, environmentally resistant, even hazardous materials, such as radioactive materials where other methods fail. The method being a one-step non-contact process can be applied to non-planar, and in principle to arbitrarily shaped, substrates. This latter feature represents another unique advantage of the scheme. However, some of the disadvantages of the method or unsolved technological problems at the present are: etching quality being material dependent, difficulty in monitoring the etch depth, and limitation of the minimum etch size due to diffraction effects in the optical system.

The invention will now be particularly described with reference to the following drawings in which:

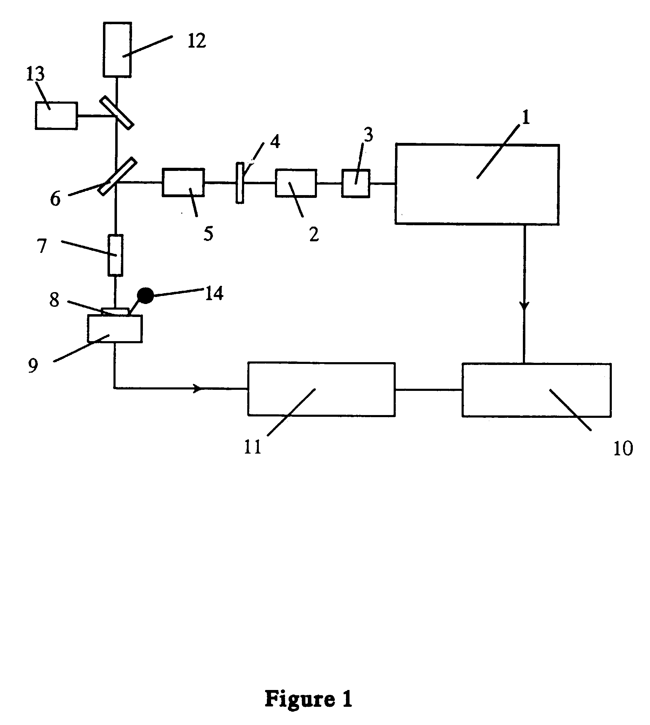

Fig. 1 is a schematic layout of the exemplar advanced apparatus used in the fabrication of surface relief microstructures by use of an excimer laser. A pulsed KrF excimer laser 1, emitting UV radiation at 248nm, delivers a sequence of high energy laser pulses, of about twenty (20) nanosecond duration. The excimer laser beam 1 is directed through a series of mirrors (not appearing in Fig. 1) to the illumination system 2, having passed through the laser beam attenuator 3. Subsequently it is incident on a beam modulation mask 4, relayed onto the substrate 8 via optical system 5 and objective lens 7, which optical system is characterized by high demagnification imaging with conjugate planes 4 and 8. The mask representing the master pattern of the computer generated hologram, designed using, for example, the simulated annealing algorithm, is, in this particular exemplar form, fabricated on a chrome-on-quartz substrate by standard optical lithography methods. Laser operation is controlled by the electronic system 10. The substrate (target) material 8 is located on a x-y-z translation stage 9, with positioning accuracy of the order of 25 nm. The translation stage is driven by piezoelectric motors and motion is controlled by the electronic Unit 11 which is coupled to the system 10. Motion along the Z-axis may be used in combination with an automatic focusing system. The mask pattern is copied with strong reduction (about 25 times) on the target substrate surface via the previously described selective ablative etching process. The requirement of strong demagnification constitutes a particular characteristic of the method. Consecutive step-and-repeat projection produces etching of the desired pattern on the target. This pattern may consist of a periodic replication of the said master-hologram-mask. During fabrication, the target area can be viewed through an imaging system including a dichroic mirror 6, a CCD camera 12 as well as the microscope ocular lenses 13. Because of the weight of the whole system a mechanical balancing system 14 is used to stabilize the arrangement and prevent platform deformation and possible damage induced by excessive stress to the microscope gearing system.

In one embodiment of the invention direct laser microetching is used to fabricate computer generated holograms by master-hologram-mask projection. The said master-hologram-mask may consist of a metallic-coated (for example chrome on amorphous SiO₂) or a high-reflection multilayer dielectric-coated transparent dielectric material. The metallic or dielectric coating has been selectively etched to allow transmission of radiation and spatially modulate the intensity of the optical beam. Photoablation of the substrate by this spatially modulated beam produces a corresponding surface relief holographic pattern. The etch depth is a function of energy density, number of pulses and pulse repetition rate as well as the nature of the target material. These holograms can be of the Fourier type, Fresnel type and the like. Fourier CGH's may be designed using the simulated annealing algorithm, whereas Fresnel CGH's may be designed by the generalized error diffusion algorithm. Both of these algorithms yield the smallest possible error between the reconstructed pattern (diffracted light from the hologram) and the primary ideal object pattern. Step-and-repeat replication of the mask (consisting, for example, of a one-period pattern) onto the substrate yields complete holograms realized as surface microrelief diffraction structures. These holograms can be fabricated on a variety of solid materials, such as metals, metal alloys (for example stainless steel), polymers and other crystalline and non-crystalline solid materials not excluding classical optical elements, optical fibers, waveguides and the like. In principle, no restriction on the curvature of the substrate surface exists, but specific design of the hologram is required in each particular case. Depending on the nature of the substrate material used, transmissive and/or reflective holographic elements can be fabricated. Upon suitable hologram reconstruction, the desired pattern image of the design object is reproduced. Depending on the specific application, a large variety of CGH patterns can be provided, from relatively simple optical interconnect array patterns to generic object holograms.

According to another embodiment of the invention the step-and-repeat method is applied to fabricate master diffractive structures on metal or dielectric coated short-wavelength (for example ultraviolet)-transparent substrates. This is accomplished by replicative etching of simple rectangular and/or circular, and the like, metal masks of relatively large feature dimensions (for example of the order of mm). Subsequently, these grating-patterns are used in the same system as the master masks for etching Bragg gratings, CGH gratings and the like, on various substrates according to specific requirements.

In a further embodiment of the invention optical diffractive elements are produced by etching each individual picture element to the design etch-depth. In this case the whole fabrication is fully automated by interfacing the laser operation control with the translation stages control through a user-friendly software program. By this means, any arbitrary pixellated pattern with two (binary) or more than two levels (multilevel) of etch-depth (corresponding to phase changes of the wavefront by two or more values respectively) can be produced. Computer-aided-design software may be used for designing the master pattern. The designed pattern is thereafter directly transferred to the surface of the substrate (target) by translating the substrate and subsequently laser-etching it at predetermined coordinates (raster or vector scanning). Therefore, this method allows the direct (one-step) fabrication of microstructures having arbitrary design features, with micron or less minimum feature size. Master-hologram-masks can also be produced by etching metallic and/or dielectric high-reflection coatings on suitable transparent substrates as discussed in a previous embodiment.

Bearing in mind the inherent flexibility of the present invention, further embodiments relating to specific applications will now be described:

According to an embodiment of use of the invention, direct laser microetching is applied to fabricate specialized microoptical components. The present invention refers mainly to cases in which traditional techniques fail due to difficulties of photoresist coating methods (surface morphology) and/or due to material nature and/or due to high mass-production cost considerations. Some examples include microlenses and microlens arrays, computer generated holograms, as well as Bragg gratings in semiconductor substrates and waveguides.

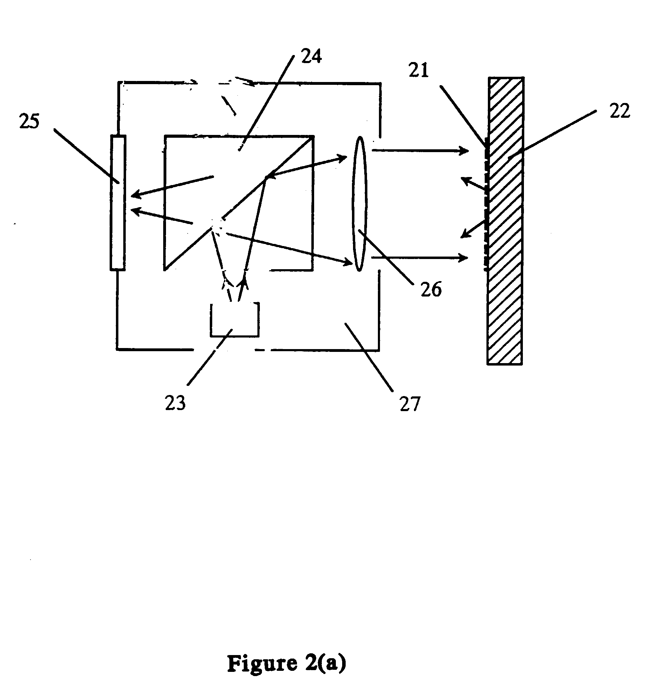

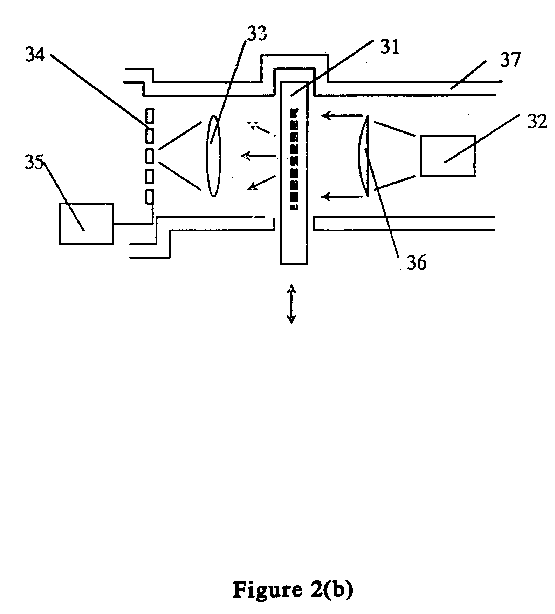

Fig. 2 relates to a further embodiment of use of the present invention. With reference to Fig. 2 (a) a CGH 21 containing information in an encoded form is etched on a solid object 22. By this means, information relating to security, identification and authenticity, classified specifications and the like, may be recorded (etched) on a permanent basis on a solid item. Applications relate to security locks, precious items, including works of art, antiquities, precious stones, jewelry and the like, or commonly used items such as credit cards, passports, currency denominations and the like, as well as military equipment, all of which can be marked discretely. Minimal damage to the item is ensured due to the small size of the CGH (of the order of 1 mm²) and the small etch-depth (<0.5 microns). In addition, due to the hologram nature minimal loss of information occurs with partial damage of the CGH grating. Reconstruction of the encoded information is performed by means of coherent (for example laser) light illumination 23 (preferably diode laser) through a beamsplitter 24. The decoded information (image) is revealed on a screen 25 which is observed by the observer after transformation by optical system 26. In a further embodiment the hologram design is such that it requires a specific optical instrument for reconstructing the original pattern. This instrument 27 may be composed of items 23, 24, 25 and 26. Specific design and diffuse illumination may relax the requirement of the observation screen 25. In a further arrangement of holographic locking, presented in Fig 2 (b), a "key" hologram 31, for example transparent in the radiation of a diode laser 32, is used in combination with an optical system 36. The hologram, which includes coded information, for example letters or numbers, is reconstructed and the beam is transformed by lens 33 and is incident on photodetector array 34. The device is encapsulated in enclosure 37. Electronic system 35 decides for unlocking. As an additional security feature, the arrangement may involve further information scrambling. and would, for example, comprise the use of a predetermined intentionally-induced aberration or encoding, which is compensated by optical or electronic schemes, such as anamorphic optics, holographic compensators and/or optical complex filtering as well as hybrid optoelectronic processing methods and the like.

In another embodiment of use of the invention CGH's and generic diffractive elements are etched on hard and/or durable material substrates such as, for example, steel and titanium alloys, ceramics and the like, of, in principle, arbitrary morphology in order to produce surface-relief hologram masters for further use in mass production processes of molding, casting, printing, and the like chemical and/or mechanical copying reproduction processes.
Three examples of particular relevance to the present embodiment will be outlined below:

First, hard surface relief masters are used for molding/casting, in mass production of micro-optical components, holographic optical disks/tapes, information storage (memory) materials, and in particular to those devices related to computer, communications, library data storage and entertainment industries.

In a second example, suitably designed masters are used for mass production of optical devices on transparent or reflective materials such as glass, transparent polymers, metal reflectors, and the like, for use in vision (for example head-up displays) and illumination (for example light concentrators/projectors) systems, in the aeronautics and automobile industries.

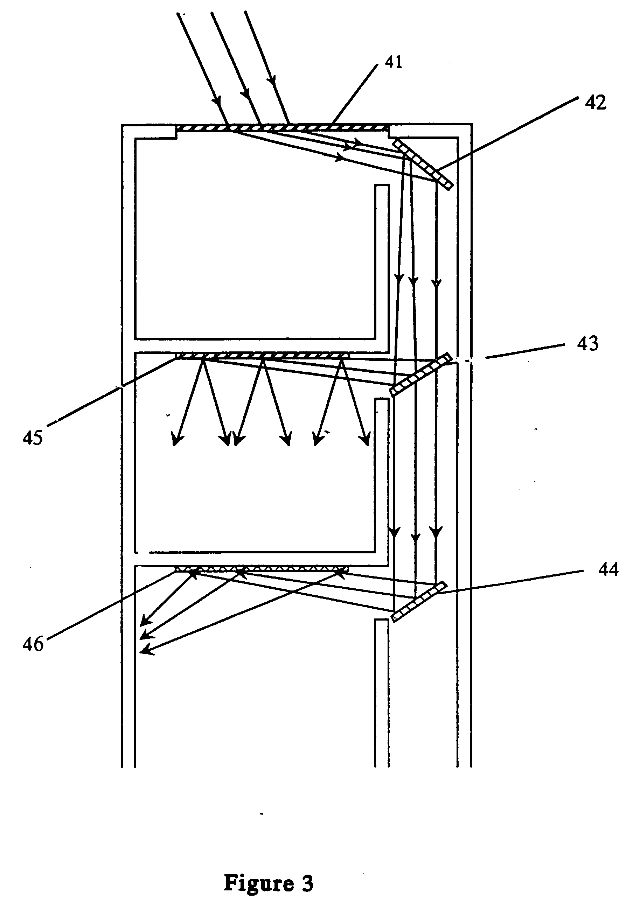

A third example relates to the building construction industry, and in particular to the manufacturing of surface relief glass and/or polymer or metal windows/surfaces. These windows/surfaces incorporate specific diffractive elements or large holograms, in order to redirect incident sunlight and/or artificial illumination for obtaining better lighting conditions, and/or special lighting effects as well as decoration. Fig. 3 depicts a typical arrangement for collecting and guiding of sunlight into the interior of a building. The incident sunlight is diffracted from the large hologram 41 and is directed through a series of mirrors 42 and 43, 44 to secondary holograms 45, 46. Depending on the design, diffracted light from the secondary holograms may have any desired distribution. In the case of hologram 45, light is distributed in the interior, while in that of 46, light is focused at specific points of the space according to the design. Specific design will allow for re-directing, concentrating, or redistributing infra-red radiation for heating/insulation applications, radiation to detector coupling applications, as well as solar radiation on solar-cell arrays for electricity generation.

## Claims

1. A microetching method for fabricating surface-relief optical microstructures of arbitrary but known topography characterized by the use of spatially modulated with high-resolution, high-intensity laser radiation to achieve via selective surface photoablation, material removal and corresponding etching of the solid target, through the process of explosive photodissociation, which target material may have arbitrary nature and geometrical shape.

2. A system architecture for application of the method for producing optical microstructures, as claimed in Claim 1, comprising of a laser radiation source, preferably emitting pulsed Ultraviolet radiation, translation stage system for target positioning, capable of moving along at least one of the three x-y-z axes with high accuracy measurement and locking of the target position, and/or laser beam delivery system capable of moving the laser beam relative to the target with high accuracy, which systems are electronically controlled and coupled with the laser emission control system, and which architecture is further characterized by the use of a high demagnification and high resolution optical system in order to achieve first, spatial modulation of the laser beam by using a master mask and imaging projection of the said mask on the target and second, by high radiation energy density on target producing explosive photodissociation and not thermal evaporation of material.

3. A microetching method according to claims 1 and 2 which makes use of the electronically controlled target or laser beam motion, to achieve repetitive microetching of the target surface through raster or vector scanned motion of the target relative to the modulated laser beam.

4. Use of the microetching method claimed in claims 1 to 3 for the production of surface-relief holographic structures of binary or multiple-phase of (algorithmically) computer-generated topography, making use of master masks for the spatial modulation of the beam, which masks may consist of either selectively drilled plates or films of opaque solid material or selectively etched metal or dielectric coatings on the surface of a transparent to the laser radiation substrate, in such a way as to exhibit the said topography of the hologram or part of this topography.

5. Use of the microetching method as claimed in claims 1 to 3 for the selective etching of reflective and/or absorptive thin films/coatings on the surface of transparent to the laser radiation material, aiming at the destruction of the conditions of reflection or/and absorption of radiation via material removal, with respective recording of the pattern topography and the creation of laser modulation mask for further use according to claims 1 to 4.

6. Use of the method according to claims 1 to 4 for the fabrication of optical microstructures on the surface of high mechanical and/or thermal and/or chemical durability aiming at the construction of surface-relief masters for further use in processes of mass reproduction (copying) of surface relief copies via the methods of printing, molding, casting, pressing and the like.

7. Use of the method according to claims 1 to 6 for the fabrication of surface relief optical microstructures, which microstructures comprise security, encoding or/and object classification information, on the surface of solid materials and items, the optical reconstruction of which holograms reveals the information, aiming to impose or lift the locking of a security system, or to the recognition or the verification of authenticity or specification of an item and the like operations.

8. Use of the method according to claims 1 to 5 and the further use according to claim 6 for the fabrication of surface relief optical microstructures with large area surfaces on transparent or reflective materials, for application in building illumination and decoration, solar or artificial radiation collection as well as in the production of display systems, light projectors, decoration items and the like substantially as described herein.
